# EUROPÄISCHE PATENTSCHRIFT

(11) **EP 0 901 155 B1**
(45) Veröffentlichungstag und Bekanntmachung des Hinweises auf die Patenterteilung: **18.08.2004**
(21) Anmeldenummer: 98810103.6
(22) Anmeldetag: 06.02.1998
(51) Int. Cl.: H01L 21/00

(54) **Halbleiter-Montageeinrichtung zum Auftragen von Klebstoff auf einem Substrat**
Semiconductor mounting assembly for applying an adhesive on a substrate
Ensemble de montage de semiconducteurs pour appliquer un adhésif sur un substrat

(30) Priorität: 05.09.1997 CH 208997
(43) Veröffentlichungstag der Anmeldung: 10.03.1999
(73) Patentinhaber: ESEC Trading SA, 6330 Cham (CH)
(72) Erfinder: Viggiano, Franco, Dr., 6330 Cham (CH); Koster, Christof, 6319 Allenwinden (CH)
(74) Vertreter: Falk, Urs, Dr.

(56) Entgegenhaltungen:
- US-A- 4 868 007
- US-A- 5 415 693

## Beschreibung

Die Erfindung bezieht sich auf eine Halbleiter-Montageeinrichtung zum Auftragen von Klebstoff auf einem Substrat im Bereich einer Chip-Montagefläche.

Die sehr verbreitete Montage von Halbleiterchips mittels Klebstoff (meist auf Epoxy-Basis) setzt einen dosierten Auftrag des Klebers in bestimmter Verteilung auf der Montagefläche voraus, damit beim nachfolgenden Aufsetzen des Chips eine möglichst gleichmässig über die ganze Chipfläche verteilte, von Lufteinschlüssen freie Klebstoffschicht entsteht. Um dies zu erreichen, kommen je nach Chipformat, Klebstoffsorte und weiteren Parametern verschiedene "figürliche" Auftragsmuster zur Anwendung, die vom einfachen Diagonalenkreuz bis zu mehrfach verzweigten Strichfiguren reichen.

Innerhalb eines als "Die Bonder" bezeichneten Montageautomaten ist für den Klebstoff-Auftrag eine besondere Einrichtung vorgesehen, die einen Dispenser über dem Substrat bewegt. Das gewünschte Auftragsmuster kann dabei auf verschiedene Art erzeugt werden: Entweder wird ein stempelartiges Dispenserwerkzeug verwendet, das eine Vielzahl von entsprechend dem Muster in Reihen angeordneten Düsen aufweist (multitube dispenser); solche Werkzeuge müssen für jedes Muster einzeln hergestellt und jeweils ausgewechselt werden. Eine andere Auftragseinrichtung weist eine Einzeldüse auf, die in einer entsprechend dem Muster programmierten Bewegung über das Substrat geführt wird und dabei die Strichfigur "zeichnet" (programmable dispenser). Ein wesentlicher Vorteil dieser Einrichtung besteht darin, dass beliebige Muster, lediglich durch Änderung der Software, mit immer demselben und relativ einfachen Werkzeug erzeugt werden können. Allerdings ist es erforderlich, die programmierten Bewegungen mit ausreichender Genauigkeit und vor allem sehr schnell auszuführen, damit auch verzweigte Muster mit kurzen Taktzeiten "gezeichnet" werden können.

Bekannte Einrichtungen der letztgenannten Art weisen folgende Merkmale auf:
- Einen in drei Koordinatenrichtungen (x, y, z) beweglichen Klebstoff-Dispenserkopf,
- einen ersten Schlitten, der in zwei zur Montagefläche parallelen Richtungen (x, y) mittels zugehörigen ersten und zweiten Stellantrieben bewegbar ist, und
- einen zweiten Schlitten, der an einer mit dem ersten Schlitten verbundenen Führung in der dritten, zur Montagefläche senkrechten Richtung (z) mittels einem dritten Stellantrieb bewegbar ist und der den Dispenserkopf trägt.

Dabei handelt es sich bei der einen bekannten Ausführung um einen "klassischen" dreiachsigen Stellmechanismus mit drei überlagerten, je mit Stellantrieb versehenen Schlitten, und in einem anderen Fall sind die x- und y-Stellantriebe des ersten Schlittens zwar entkoppelt, der dritte (z-) Stellantrieb samt Schlitten ist dagegen auf dem ersten x/y-Schlitten montiert und wird von diesem mitbewegt. Bei solchen Einrichtungen nach dem Stand der Technik ist es schwierig, die erforderliche mechanische Stabilität und Stellgenauigkeit über den ganzen, dreiachsigen Arbeitsbereich zu erreichen. Vor allem sind aber die erreichbaren Beschleunigungen und Geschwindigkeiten der Stellbewegungen begrenzt, denn das Gewicht leistungsstarker Stellmotoren bedingt wiederum entsprechend stabile Schlittenführungen, was insgesamt zu immer grösseren bewegten Massen führt.

Mit der Erfindung wird angestrebt, die Nachteile und Begrenzungen des Standes der Technik zu überwinden und die dynamischen Eigenschaften solcher Einrichtungen zu verbessern mit dem Ziel, höhere Beschleunigungen und Stellgeschwindigkeiten des Dispenserkopfes und damit kürzere Taktzeiten beim "Schreiben" der Klebstoffmuster zu erreichen.

Diese Aufgabe wird erfindungsgemäss durch eine Halbleiter-Montage einrichtung gemäß Anspruch 1 gelöst.

Mit der erfindungsgemässen Bauweise wird insbesondere eine drastische Reduktion der bewegten Masse und damit der Beschleunigungskräfte im Bereich des Dispenserkopfes erreicht. Indem der Stellmotor und der Hilfsschlitten des dritten Stellantriebs ortsfest angeordnet sind, ist der den Dispenserkopf tragende zweite (z-) Schlitten von deren Massen befreit und entsprechend leicht. Dies erlaubt erhöhte Beschleunigungen in allen drei Koordinatenrichungen ohne Einbusse bei der Genauigkeit und der Langzeit-Stabilität.

Vorteilhafte weitere Ausgestaltungen der im Patentanspruch 1 definierten Einrichtung sind in den abhängigen Ansprüchen angegeben.

Nachstehend wird die Erfindung anhand verschiedener Ausführungsbeispiele in Verbindung mit der Zeichnung näher erläutert.
- Fig. 1: zeigt ein erstes Beispiel perspektivisch und als vereinfachte Prinzipdarstellung, mit Angabe der drei Koordinatenrichtungen,
- Fig. 2: ist die Stirnansicht (in y-Richtung gesehen) eines zweiten Ausführungsbeispiel, und
- Fig. 3: die Seitenansicht (in x-Richtung gesehen) des zweiten Ausführungsbeispiels, ebenfalls vereinfacht dargestellt, wenn auch mit mehr konstruktiven Details.

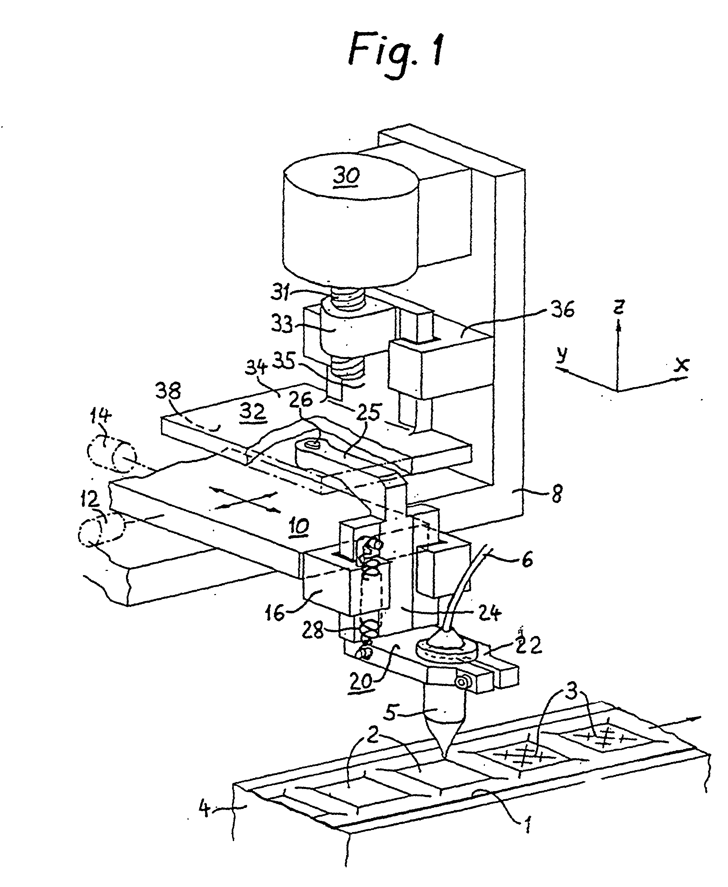

Die in Fig. 1 dargestellte Einrichtung zum Auftragen von Klebstoff bei der Halbleitermontage ist als Bestandteil eines Die Bonders auf einer ortsfesten Basisstruktur 8 aufgebaut. Im Die Bonder wird in an sich bekannter Weise ein Substrat 1, z.B. ein metallischer, streifenörmiger "Leadframe", auf einer Unterlage 4 mittels einer (nicht dargestellten) Transportvorrichtung schrittweise in Pfeilrichtung weiterbewegt. Das Substrat 1 weist Chip-Montageflächen 2 auf (auch "Chip-Inseln" genannt), auf denen mittels eines in drei Koordinatenrichtungen x, y und z beweglichen Dispenserkopfes 5 je ein Klebstoffmuster 3 aufgetragen wird. Der fliessfähige Klebstoff, typischerweise auf Epoxy-Basis, wird über eine flexible Leitung 6 zugeführt und z.B. mittels einer bekannten, nicht dargestellten volumetrischen Pumpe dosiert. Wie bekannt, wird auf dem im Die Bonder weitertransportierten Substrat 1 anschliessend jeweils ein Chip auf ein Klebstoffmuster 3 aufgesetzt, wodurch der Kleber sich über die Fläche des Chips verteilt und diesen mit dem Substrat verbindet.

Der Klebstoff wird häufig als ein von den Diagonalen der Montagefläche 2 ausgehendes, verzweigtes Strichmuster aufgetragen. Hierzu muss der Dispenserkopf 5 in einer programmierten Sequenz in x- und y-Richtung bewegt werden, während die Dispensermündung auf genau vorgegebenem Abstand über der Montagefläche 2 gehalten wird; für Strichunterbrechungen wie auch beim Vorschub des Substrats 1 muss der Dispenserkopf angehoben werden (z-Richtung). Alle diese Bewegungen müssen mit hoher Präzision erfolgen und zur Erzielung kurzer Taktzeiten möglichst schnell ablaufen.

Zur Führung des Dispenserkopfes 5 in x- und y-Richtung, also parallel zur jeweiligen Montagefläche 2, dient ein auf der Basis 8 montierter, erster Schlitten 10 mit zugehörigen (ersten und zweiten) Stellantrieben 12 und 14. Diese Komponenten sind nur schematisch dargestellt und können auf verschiedene, an sich bekannte Arten realisiert werden. Es kann sich z.B. um einen Kreuztisch mit Längs- und Querschlitten handeln (wobei nur z.B. der x-Stellantrieb ortsfest montiert ist und der y-Antrieb in x-Richtung mitfährt); vorzugsweise sind jedoch die x- und y-Richtungen "entkoppelt" und beide Antriebe 12 und 14 stationär.

Mit dem Schlitten 10 ist eine Führung 16 verbunden, die einen zweiten Schlitten 20 in der zur Montagefläche 2 senkrechten z-Richtung verschiebbar führt. Der im wesentlichen winkelförmige Schlitten 20 ist am einen Schenkel bei 22 zur auswechselbaren Halterung des Dispenserkopfes 5 eingerichtet, während der andere Schenkel 24 mit in der Führung 16 laufenden Führungsbahnen versehen ist.

Als (dritter) Stellantrieb für die Bewegungen des Schlittens 20 in z-Richtung dient folgende Anordnung:

Ein Stellmotor 30 ist ortsfest an der Basis 8 montiert. In einer ebenfalls ortsfesten Führung 36 ist, angetrieben vom Motor 30, ein Hilfsschlitten 32 in z-Richtung, also wiederum senkrecht zur Montagefläche 2, verschiebbar. Als Antriebsverbindung ist beim vorliegenden Beispiel ein Spindeltrieb vorgesehen, mit einer Gewindespindel 31, die spielfrei in die Mutter 33 am Hilfsschlitten 32 eingreift. Der letztere weist einen horizontalen Schenkel 34 und einen vertikalen, in der Führung 36 gleitenden Schenkel 35 auf. Der horizontale Schenkel bildet mit seiner Unterseite eine Stellfläche 38, die genau plan bearbeitet und parallel zur Montagefläche 2 des Substrats 1 (bzw. zur Auflagefläche der Substrat-Unterlage 4) ausgerichtet ist. Die Ausdehnung der Stellfläche 38 entspricht mindestens dem Fahrbereich des Schlittens 10 in x- und y-Richtung bzw. dem Arbeitsbereich des Dispenserkopfes 5. Mit der Stellfläche 38 wirkt ein am Schlitten 20 vorhandener Anschlag 25, 26 zusammen, der in steter Berührung mit der Stellfläche 38 gehalten ist. Der dauernde Kontakt wird von unten mittels einer Zugfeder 28 sichergestellt, die zwischen dem Schlitten 20 und seiner Führung 16 verspannt ist.

Wie dargestellt, ist hier der Anschlag als Gleitkopf ausgebildet, mit einem (vorzugsweise auswechselbaren) Einsatz 26 aus Gleitwerkstoff, der über die Stellfläche 38 gleitet. Durch geeignete Wahl des Gleitwerkstoffes (z.B. ein Feststoff-Gemisch auf der Basis von Graphit) bzw. der Werkstoffpaarung ist gewährleistet, dass die Stellfläche 38 keinen Abrieb erfährt. - Es wäre auch denkbar, den Anschlag anstatt mit einem Gleitkopf mit einer rollenden Kugel o.dgl. auszubilden.

Beim Betrieb der Einrichtung nach Fig. 1 werden die programmierten, schnellen "Schreib"-Bewegungen des Dispenserkopfes 5 in x- und y-Richtung von den Stellantrieben 12 und 14 über den Schlitten 10 ausgeführt; die Höhenlage des Kopfes 5 (z-Wert) ist dabei durch die Stellung des Hilfsschlittens 32 über den Anschlag 25, 26 gegeben. Vom Schlitten 10 muss - ausser dem Kopf 5 - immer nur der relativ leichte Schlitten 20 bewegt werden, unbelastet vom Stellantrieb in z-Richtung, da der Motor 30 und der Hilfsschlit-ten 32 ortsfest gelagert sind und somit von deren Masse keine Beschleunigungskräfte am Schlitten 20 auftreten.

Für die vertikalen Bewegungen des Schlittens 20 mit dem Kopf 5 muss der Motor 30 (zusätzlich) den Hilfsschlitten 32 bewegen und die Kraft der Feder 28 überwinden. Mit dem stationär gelagerten Motor 30 kann dies ohne besondere Probleme erreicht werden. In dynamischer Hinsicht und für die Regelung der z-Position muss der stete Kontakt des Gleiteinsatzes 26 mit der Stellfläche 38 sichergestellt sein. Kritisch bei der gegebenen Anordnung ist das Stoppen des Schlittens 20 nach schnellem Absenken auf Sollhöhe. Diesbezüglich ist es von Vorteil, dass die Kraft der Zugfeder 28 nach tieferen Positionen des Schlittens 20 zunimmt und damit der Tendenz des Abhebens von der Fläche 38 stärker entgegenwirkt.

Der Dispenserkopf 5 ist, wie weiter oben erwähnt, auswechselbar. Insbesondere kann die Einrichtung anstatt mit einem "schreibenden" Dispenserkopf nach Fig. 1 auch mit einem stempelartigen ("multitube") Kopf betrieben werden. Ein solcher erfordert in der Regel nur Bewegungen in z-Richtung (in x und y allenfalls zum Einmitten des Kopfes über der Montagefläche 2 oder zum vorübergehenden Entfernen aus der Arbeitsposition). Um unterschiedliche Massen verschiedener Dispenserköpfe zu berücksichtigen, kann die Feder 28 ausgewechselt oder deren Vorspannung verändert werden.

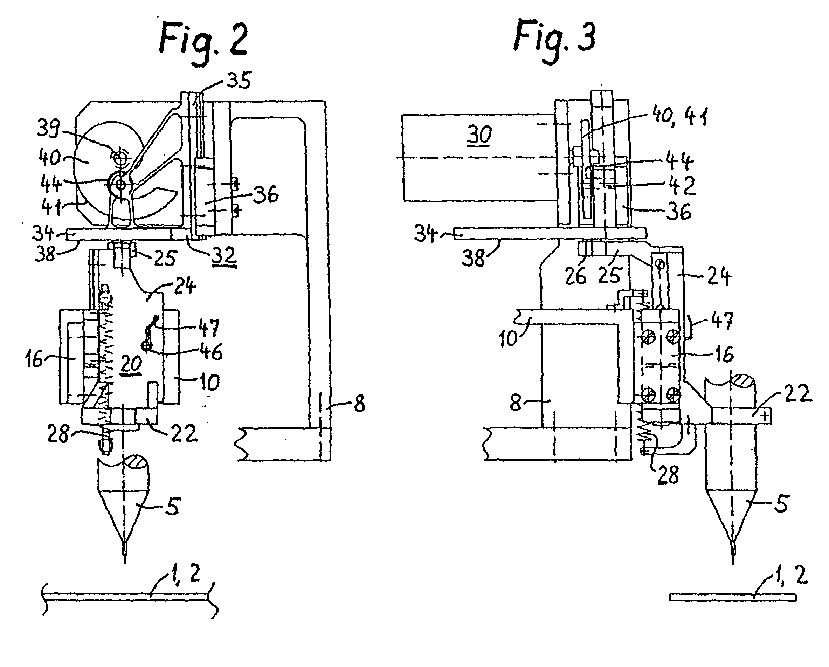

Beim weiteren Ausführungsbeispiel nach Fig. 2 und 3 sind die Teile, die bezüglich ihrer Funktion mit Teilen des ersten Beispiels übereinstimmen, mit gleichen Bezugszahlen bezeichnet wie in Fig. 1, auch wenn sie etwas abweichend gestaltet oder angeordnet sind. Nicht weiter dargestellt sind die Stellantriebe und die Lagerung des x-y-Schlittens 10.

Bei der Einrichtung nach Fig. 2 und 3 ist vor allem die Antriebsverbindung zwischen dem Stellmotor 30 und dem Hilfsschlitten 32 anders als bei Fig. 1 gelöst:

Auf der Rotorwelle 39 des Motors 30 ist eine Kurvenscheibe 40 drehfest montiert. Mit der Steuerkurve 41 der Kurvenscheibe wirkt ein Rollenkopf 44 zusammen, der auf einem im Hilfschlitten 32 festsitzenden Achsbolzen 42 gelagert ist. Die spielfreie Auflage des Rollenkopfes an der Steuerkurve wird hier durch die Kraft der Feder 28 aufrechterhalten, die sich über den Gleiteinsatz 26 auf den Hilfsschlitten und damit auf den Rollenkopf überträgt. Es wäre jedoch auch möglich, für diesen Zweck eine separate, zwischen dem Hilfsschlitten 32 und der Basisstruktur 8 verspannte Feder vorzusehen.

Als Stellmotor 30 eignet sich insbesondere ein Gleichstrommotor oder auch ein Schrittmotor bekannter Bauart (dies gilt auch für die x- und y-Stellmotoren 12 und 14, Fig. 1). Da bei der gegebenen Anordnung die Auflagekraft des Rollenkopfes 44 an der steigenden Steuerkurve 41 ein Drehmoment an der Rotorachse 39 bewirkt, muss vom Motor 30 ein entsprechendes Gegenmoment aufgebracht werden, um eine bestimmte z-Position halten zu können. Im Interesse eines niedrigen Motor-Haltemoments ist eine möglichst geringe Steigung der Steuerkurve 41 anzustreben. In diesem Zusammenhang erweist sich für die Steuerkurve eine lineare Spirale (Radius mit dem Drehwinkel linear zunehmend) als vorteilhaft; wie aus Fig. 2 ersichtlich, ist es zweckmässig, wenn die Spirale sich über mehr als 360° erstreckt, um bei niedriger Steigung den erforderlichen Fahrhub in z-Richtung zu erzeugen.

Mit zunehmender Dehnung der Feder 28, d.h. nach tieferen Positionen des Schlittens 20, nimmt die Kraft der Feder und damit die Auflagekraft des Rollenkopfes 44 an der Steuerkurve 41 zu. Ein entsprechender Anstieg des erforderlichen Motor-Haltemomentes wird jedoch teilweise dadurch kompensiert, dass bei der gegebenen Spirale der Winkel zwischen deren Tangente und dem Radius mit zunehmendem Radius kleiner wird. - Bei der Dimensionierung der Steuerkurve 41 und der Feder 28 ist auch darauf zu achten, dass bei allen im Betrieb auftretenden Beschleunigungen des Schlittens 20 mit dem Dispenserkopf 5 der Kontakt zwischen dem Anschlag 25, 26 und der Stellfläche 38 erhalten bleibt.

In Fig. 2 ist noch der Einbau eines Sensors 46 mit Messleitung 47 am Schlitten 20 bzw. in dessen Schenkel 24 angedeutet. Es handelt sich um Bestandteile einer an sich bekannten, nicht weiter dargestellten Messanordnung zur laufenden Bestimmung der Schlittenposition in z-Richtung (z.B. ein Fototransistor als Impulsgeber in Verbindung mit einem in der Führung 16 eingebauten Glasmassstab; selbstverständlich ist auch der umgekehrte Einbau möglich). Eine Messanordnung an diesem Ort ist von besonderem Vorteil als Istwertgeber in einem Positions-Regelkreis zur Steuerung des Stellmotors 30, indem sie direkt "an vorderster Stelle" die z-Position der Dispensermündung (nach Eichung in bezug auf die Höhe des Substrats 1) misst. Dank der Regelung der z-Posizion des Schlittens 20 bzw. der Stellfläche 38 mittels des Signales des Sensors 46 wird ein allfälliger Abrieb des Gleitkopfes kompensiert.

Die Einrichtung lässt sich auch verwenden, um Klebstoff mit einem Stempel, d.h. ohne Schreibbewegung des Dispenserkopfes in x- und/oder y-Richtung, auf die Chip-Montageflächen 2 aufzutragen. Für diese Verwendung sind nicht dargestellte Justierungsmittel vorgesehen, mit denen die Basisstruktur 8 so verstellbar ist, dass die Kanten des Stempels planparallel zu den Chip-Montageflächen 2 sind und daher formschlüssig auf den Chip-Montageflächen 2 aufliegen.

## Patentansprüche

1. Halbleiter-Montageeinrichtung zum Auftragen von Klebstoff auf einem Substrat (1) im Bereich einer Chip-Montagefläche (2), mit einem in drei Koordinatenrichtungen (x, y, z) beweglichen Klebstoff-Dispenserkopf (5), einem ersten Schlitten (10), der in zwei zur Montagefläche (2) parallelen Richtungen (x, y) mittels zugehörigen ersten und zweiten Stellantrieben (12, 14) bewegbar ist, und einem zweiten Schlitten (20), der an einer mit dem ersten Schlitten (10) verbundenen Führung (16) in der dritten, zur Montagefläche (2) senkrechten Richtung (z) mittels eines dritten Stellantriebs bewegbar ist und der den Dispenserkopf (5) trägt, wobei der dritte Stellantrieb einen ortsfest gelagerten Stellmotor (30) und einen von diesem angetriebenen Hilfsschlitten (32) aufweist, der an einer ortsfesten Führung (36) in der dritten Richtung (z) verschiebbar ist und eine zur Montagefläche (2) parallele Stellfläche (38) aufweist, und wobei der zweite Schlitten (20) mit einem Anschlag (25, 26) versehen ist, der in steter Berührung mit der Stellfläche (38) des Hilfsschlittens (32) gehalten ist.

2. Einrichtung nach Anspruch 1, **dadurch gekennzeichnet, dass** die Stellfläche (38) durch die dem Substrat (1) zugekehrte Unterseite des Hilfsschlittens (32) gebildet ist und der Anschlag (25, 26) mittels einer zwischen dem zweiten Schlitten (20) und seiner Führung (16) verspannten Feder (28) von unten gegen die Stellfläche (38) gehalten ist.

3. Einrichtung nach Anspruch 1 oder 2, **dadurch gekennzeichnet, dass** der Anschlag (25, 26) durch einen Gleitkopf gebildet ist und einen Einsatz (26) aus Gleitwerkstoff aufweist, der Gleitbewegungen entlang der Stellfläche (38) ohne Abrieb an derselben gewährleistet.

4. Einrichtung nach einem der Ansprüche 1 bis 3, **dadurch gekennzeichnet, dass** der dritte Stellantrieb eine vom Stellmotor (30) angetriebene Kurvenscheibe (40) und einen mit deren Steuerkurve (41) zusammenwirkenden, am Hilfsschlitten (32) gelagerten Rollenkopf (44) umfasst.

5. Einrichtung nach Anspruch 4, **dadurch gekennzeichnet, dass** die Steuerkurve (41) eine Spirale ist und sich über einen Drehwinkel von mehr als 360° erstreckt.

6. Einrichtung nach Anspruch 5, **dadurch gekennzeichnet, dass** die Spirale eine lineare Spirale ist.

7. Einrichtung nach einem der Ansprüche 1 bis 6, **dadurch gekennzeichnet, dass** am zweiten Schlitten (20) und an der Führung (16) miteinander zusammenwirkende Wegmessmittel (46, 47) angebracht sind zur Bestimmung von dessen Istposition in der dritten Richtung (z) und dass ein Positions-Regelkreis zur Steuerung des dritten Stellmotors (30) vorhanden ist, wobei das Ausgangssignal der Wegmessmittel (46, 47) als Ist-Wert dem Positions-Regelkreis zugeführt wird.

## Claims

1. Semi-conductor mounting apparatus for applying adhesive to a substrate (1) in the area of a chip mounting surface (2), with an adhesive dispensing head (5) moveable in three coordinate directions (x, y, z), a first carriage (10), which is moveable in two directions (x, y) parallel to the mounting surface (2) by means of associated first and second actuators (12, 14), and a second carriage (20) which is moveable on a guide (16) connected to the first carriage (10) in the third direction (z) perpendicular to the mounting surface (2) by means of a third actuator and carries the dispensing head (5), whereby the third actuator comprises a positioning motor (30) mounted in a stationary manner and an auxiliary carriage (32) driven by said motor (30), which auxiliary carriage (32) is displaceable on a stationary guide (36) in the third direction (z) and is provided with a positioning surface (38) which is parallel to the mounting surface (2), and whereby the second carriage (20) is provided with a stop (26, 28) which is kept in constant contact with the positioning surface (38) of the auxiliary carriage (32).

2. Apparatus according to claim 1, **characterised in that** the positioning surface (38) is formed by the underside of the auxiliary carriage (32) facing the substrate (1), and the stop (26, 28) is held from below against the positioning surface (38) by means of a spring (28) tensioned between the second carriage (20) and the guide (16) thereof.

3. Apparatus according to claim 1 or 2, **characterised in that** the stop (26, 28) is formed by a gliding head and is provided with an insert (26) made from gliding material which ensures gliding movements along the positioning surface (38) without abrasion of said surface.

4. Apparatus according to one of claims 1 to 3, **characterised in that** the third actuator comprises a cam plate (40) driven by the positioning motor (30) and a roller head (44) mounted on the auxiliary carriage (32) cooperating with the cam (41) of said cam plate.

5. Apparatus according to claim 4, **characterised in that** the cam (41) is a spiral and its angle of rotation extends over more than 360 °.

6. Apparatus according to claim 5, **characterised in that** the spiral is a linear spiral.

7. Apparatus according to one of claims 1 to 6, **characterised in that** position measuring means (46, 47) working together are incorporated on the second carriage (20) and on the guide (16) for determining the actual position of the second carriage (20) in the third direction (z) and that a position control loop for controlling the third actuator (30) is present, whereby the output signal of the position measuring means (46, 47) is fed to the position control loop as value of the actual position.

## Revendications

1. Dispositif de montage de semi-conducteurs pour l'application de colle sur un substrat (1) au niveau d'une surface de montage de puces (2), avec une tête de distribution de colle (5) mobile sur trois axes de coordonnées (x, y, z), un premier chariot (10) mobile sur deux axes (x, y) parallèles à la surface de montage (2) au moyen d'un premier et d'un second entraînements de réglage (12, 14) correspondants, et un deuxième chariot (20) qui est mobile sur le troisième axe (z) perpendiculaire à la surface de montage (2) sur un guide (16) relié au deuxième chariot (10) au moyen d'un troisième entraînement de réglage et qui porte la tête de distribution (5), le troisième entraînement de réglage présentant un moteur de réglage (30) supporté de manière fixe et un chariot auxiliaire (32) entraîné par celui-ci, qui est mobile sur le troisième axe (z) sur un guide fixe (36) et présente une surface de réglage (38) parallèle à la surface de montage (2), et le deuxième chariot (20) étant pourvu d'une butée (25, 26) qui est en contact permanent avec la surface de réglage (38) du chariot auxiliaire (32).

2. Dispositif selon la revendication 1, **caractérisé en ce que** la surface de réglage (38) est formée par la face inférieure du chariot auxiliaire (32) tournée vers le substrat (1) et la butée (25, 26) est retenue par en-dessous contre la surface de réglage (38) au moyen d'un ressort (28) tendu entre le deuxième chariot (20) et son guide (16).

3. Dispositif selon la revendication 1 ou 2, **caractérisé en ce que** la butée (25, 26) est formée par une tête coulissante et présente un insert (26) en matériau glissant qui garantit les mouvements de glissement le long de la surface de réglage (38) sans frottement sur celle-ci.

4. Dispositif selon l'une quelconque des revendications 1 à 3, **caractérisé en ce que** le troisième entraînement de réglage comprend un disque à came (40) entraîné par le moteur de réglage (30) et une tête à rouleau (44) coopérant avec la came (41) de celui-ci et portée par le chariot auxiliaire (32).

5. Dispositif selon la revendication 4, **caractérisé en ce que** la came (41) est une spirale et s'étend sur un angle de rotation de plus de 360°.

6. Dispositif selon la revendication 5, **caractérisé en ce que** la spirale est une spirale linéaire.

7. Dispositif selon l'une quelconque des revendications 1 à 6, **caractérisé en ce qu'**il est prévu sur le deuxième chariot (20) et sur le guide (16) des moyens pour mesurer la distance (46, 47) coopérant ensemble pour déterminer leur position réelle sur le troisième axe (z) et **en ce qu'**il est prévu un circuit de régulation de la position pour la commande du troisième entraînement de réglage (30), le signal de sortie des moyens pour mesurer la distance (46, 47) étant transmis comme valeur réelle au circuit de régulation de la position.
